# EUROPEAN PATENT APPLICATION

(11) **EP 2 026 410 A1**
(43) Date of publication of application: **18.02.2009**
(21) Application number: 08162244.1
(22) Date of filing: 12.08.2008
(51) Int. Cl.: H01Q 1/24, H01Q 9/04

(54) **Intenna connecting apparatus**

(30) Priority: 13.08.2007 KR 20070081360
(71) Applicant: Jung, Young Seok, Seoul (KR)
(72) Inventor: Jung, Young Seok, Seoul (KR)
(74) Representative: Myon, Gérard Jean-Pierre

(57) **Abstract**

An intenna connecting apparatus (20) for electrically connecting an intenna (2), which is inserted into a mobile communication terminal, to a printed circuit substrate (10) installed below the intenna is provided. The intenna connecting apparatus (20) includes a conductive plate (30) electrically connected to circuit patterns (11) of the printed circuit substrate, and a conductive medium (40) installed on an upper surface of the conductive plate, the conductive medium including an elastic polymer material (41) and a plurality of conductors (42) contained in the elastic polymer material, wherein as the intenna is pressed down on the conductive medium, the conductive medium is compacted and the conductors (42) come into contact with each other, and thus the intenna (2) and the circuit patterns (11) of the printed circuit substrate (10) are electrically connected to each other.

## Description

### CROSS-REFERENCE TO RELATED PATENT APPLICATION

This application claims the benefit of Korean Patent Application No. 10-2007-0081360, filed on August 13, 2007, in the Korean Intellectual Property Office, the disclosure of which is incorporated herein in its entirety by reference.

### BACKGROUND OF THE INVENTION

### 1. Field of the Invention

The present invention relates to an intenna connecting apparatus, and more particularly, to an intenna connecting apparatus that allows an electrical connection of an intenna to circuit patterns of a printed circuit board (PCB) to be stable even when the intenna connecting apparatus is used for a long period of time.

### 2. Description of the Related Art

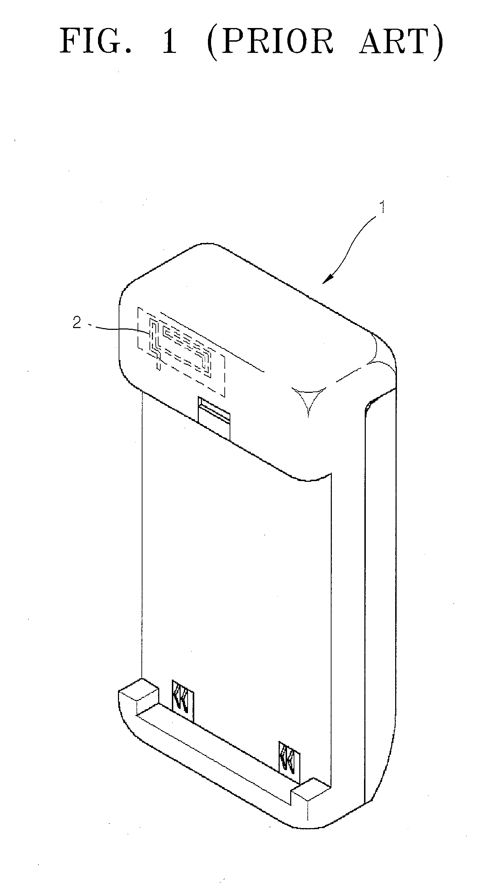

Built-in antennas (otherwise known as "intennas") are conventionally known. FIG. 1 is an illustration of an intenna 2 which is a built-in antenna. In contrast with an antenna installed outside a mobile communication terminal, the intenna 2 is installed within a mobile communication terminal 1 and transmits and receives a signal to and from an external source. When the intenna 2 is installed within a mobile communication terminal as described above, the intenna 2 is prevented from protruding outside the terminal, and thus the overall size of the mobile communication terminal is reduced. Consequently, such mobile communication terminals including the intenna 2 are more convenient as portable devices.

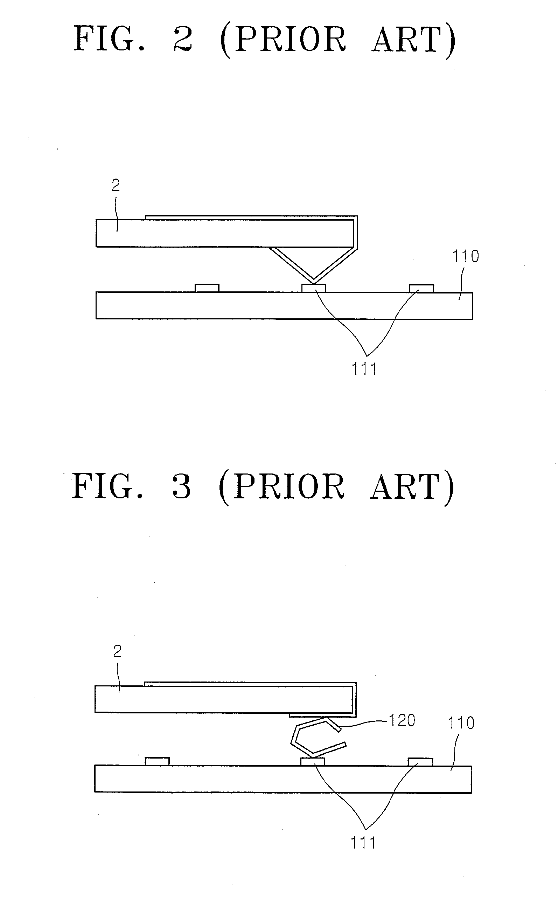

The intenna 2 is electrically connected to a printed circuit board (PCB) 110 (see FIG. 2) by an intenna connecting apparatus and thus receives an electrical signal from the PCB 110 or receives an electrical signal from an external source and transmits the electrical signal to the PCB 110.

In a conventional method of connecting the intenna 2 to the PCB 110, as illustrated in FIG. 2, first, the intenna 2 may be electrically connected directly to circuit patterns 111 of the PCB 110 via extensions of the intenna 2. In this method, conductive tape/ink or stainless steel (SUS) is used to form an electrical wave transceiving apparatus of the intenna 2. However, when conductive tape/ink or stainless steel (SUS) is used, an insulation failure may occur when the intenna 2 contacts the circuit patterns 111 of the PCB 110.

Instead of directly contacting the PCB 110 as illustrated in FIG. 2, the intenna 2 may be connected to the circuit patterns 111 of the PCB 110 via a special C-shaped clip 120 connected to the intenna 2, as illustrated in FIG. 3. The special C-shaped clip 120 is fixed to the circuit patterns 111 of the PCB 110 by soldering. However, when the special C-shaped clip 120 is used for a long time, the tension of a curved central portion of the special C-shaped clip 120 gradually decreases, and thus a contact failure may occur. In addition, the curved central portion of the special C-shaped clip 120 is easily destroyed.

### SUMMARY OF THE INVENTION

The present invention provides an intenna connecting apparatus that allows an electrical connection of an intenna to circuit patterns of a printed circuit board (PCB) to be stable even when the intenna connecting apparatus is used for a long period of time.

### BRIEF DESCRIPTION OF THE DRAWINGS

The above and other features and advantages of the present invention will become more apparent by describing in detail exemplary embodiments thereof with reference to the attached drawings in which:
FIG. 1 is a perspective view of a mobile communication terminal in which an intenna is installed;
FIG. 2 is a cross-sectional view of a conventional intenna connecting apparatus;
FIG. 3 is a cross-sectional view of another conventional intenna connecting apparatus;
FIG. 4 is a cross-sectional view of an intenna connecting apparatus according to an embodiment of the present invention;
FIG. 5 is a cross-sectional view illustrating a compressed state of a conductive medium of FIG. 4;
FIG. 6 is a cross-sectional view of an intenna connecting apparatus according to another embodiment of the present invention;
FIG. 7 is a cross-sectional view of an intenna connecting apparatus according to another embodiment of the present invention;
FIG. 8 is a cross-sectional view of an intenna connecting apparatus according to another embodiment of the present invention; and
FIG. 9 is a cross-sectional view of an intenna connecting apparatus according to another embodiment of the present invention;

### DETAILED DESCRIPTION OF THE INVENTION

The present invention will now be described more fully with reference to the accompanying drawings, in which exemplary embodiments of the invention are shown.

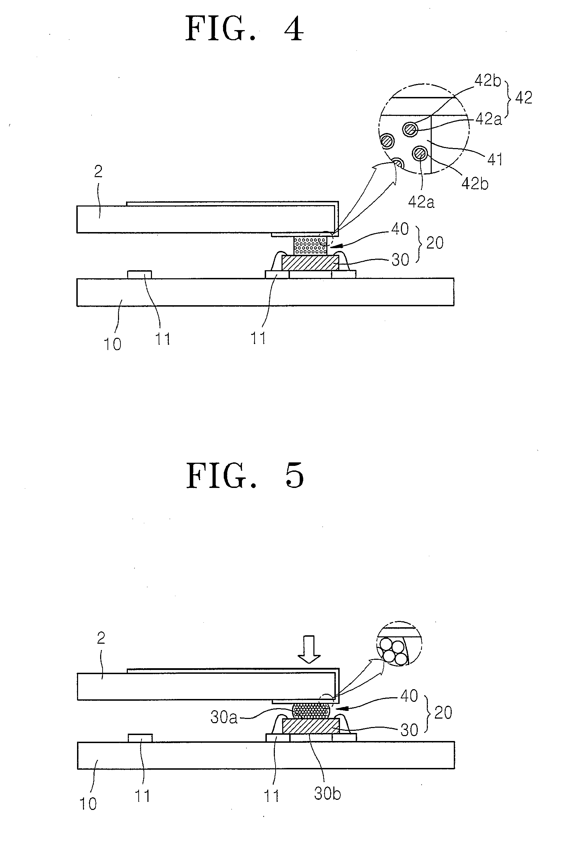

FIG. 4 is a cross-sectional view of an intenna connecting apparatus 20 according to an embodiment of the present invention. FIG. 5 is a cross-sectional view illustrating a compressed state of a conductive medium of FIG. 4.

The intenna connecting apparatus 20 is inserted into a mobile communication terminal 1 (for example that of FIG. 1) and electrically connects the intenna 2 to a printed circuit board (PCB) 10 which is installed below the intenna 2. The intenna connecting apparatus 20 includes a conductive plate 30 and a conductive medium 40.

The conductive plate 30 is electrically connected to circuit patterns 11 of the PCB 10 and is formed by plating a metal with tin (Sn) or silver (Au). The reason for the use of Sn or Au is that the conductive plate 30 is easily soldered when soldering is performed to fix the conductive plate 30 onto the circuit patterns 11 of the PCB 10. Side surface the conductive plate 30 are soldered and fixed to the circuit patterns 11 of the PCB 10.

The conductive medium 40 is disposed on an upper surface 30a of the conductive plate 30 and electrically connects the intenna 2 to the conductive plate 30. More specifically, the conductive medium 40 is disposed on the center of the upper surface 30a of the conductive plate 30. As such, as the intenna 2 is electrically connected to the conductive medium 40 and the conductive medium 40 contacts the conductive plate 30 soldered and fixed to the circuit patterns 11 of the PCB 10, the intenna 2 may be electrically connected to the circuit patterns 11 of the PCB 10. The conductive medium 40 includes an elastic polymer material 41 and conductors 42.

The elastic polymer material 41 may be a heat-resistant polymer material having a crosslinked structure. As a curable polymeric substance-forming material for obtaining such a crosslinked elastic polymeric substance, may be used various materials. Specific examples thereof include silicone rubber, conjugated diene rubbers such as polybutadiene rubber, natural rubber, polyisoprene rubber, styrene-butadiene copolymer rubber and acrylonitrile-butadiene copolymer rubber, and hydrogenated products thereof; block copolymer rubbers such as styrene-butadiene-diene block copolymer rubber and styrene-isoprene block copolymers, and hydrogenated products thereof; and chloroprene, urethane rubber, polyester rubber, epichlorohydrin rubber, ethylene-propylene copolymer rubber, ethylene-propylene-diene copolymer rubber and soft liquid epoxy rubber.

Among these, silicone rubber is preferred from the viewpoints of molding and processing ability and electrical properties. A material obtained by crosslinking or condensing liquid silicon rubber may be used as the silicon rubber. As the silicone rubber, is preferred that obtained by crosslinking or condensing liquid silicone rubber. The liquid silicone rubber preferably has a viscosity not higher than 10 ⁵poises as measured at a shear rate of 10⁻¹sec and may be any of condensation type, addition type and those having a vinyl group or hydroxyl group. As specific examples thereof, may be mentioned dimethyl silicone raw rubber, methylvinyl silicone raw rubber and methylphenylvinyl silicone raw rubber.

The conductors 42 are included in the elastic polymer material 41, and a plurality of the conductors 42 are included in the elastic polymer material 41. Each of the conductors 42 includes a metal particle 42a, serving as an internal core, and a conductive metal 42b with which the metal particle 42a is coated. As a material forming the core particles 42a, may be used that composed of a ferromagnetic metal such as nickel, iron, cobalt or an alloy thereof, that obtained by plating surfaces of inorganic substance particles such as non-magnetic metal particles or glass beads, or polymer particles with the ferromagnetic metal, or the like. The conductive metal 42b, with which the metal particle 42a is coated, may be a highly conductive metal such as gold, silver, palladium, or rhodium. It is most preferable that the metal particle 42a is a nickel particle and coated with gold, which is a highly conductive metal.

A method of coating the metal particle 42a with a conductive metal is not limited to a specific method. However, the metal particle 42a may be coated with a conductive metal by electroless plating.

The amount of conductive metal with which the metal particle 42a is coated may be 2.5 to 50 % by weight, preferably, 3 to 45 % by weight, more preferably, 3.5 to 40 % by weight, more particularly preferably, 5 to 25 % by weight, based on the metal particle 42a.

The diameter of the metal particle 42a may be 1 to 500 µm, preferably, 2 to 400 µm, more preferably, 5 to 300 µm, more particularly preferably, 10 to 150 µm. The reason why the diameter of the metal particle 42a is restricted as described above is that when the diameter of the metal particle 42a is less than 10 µm, a large number of metal particles 42a should be included in the elastic polymer material 41, thereby complicating an electrical flow path and increasing electrical loss. In other words, when the number of metal particles 42a increases, a contact area between the metal particles 42a increases and thus electrical resistance increases. Consequently, electrical loss increases. On the other hand, when the diameter of the metal particle 42a is greater than 150 µm, the size of the metal particle 42a excessively increases, and thus a vertical amount by which the conductive medium 40 can be elastically deformed is limited.

The surfaces of the conductors 42 may be treated with a coupling material such as a sealant coupling material. In this case, the adhesiveness of the conductors 42 to the elastic polymer material 41 increases, and the durability of the conductive medium 40 increases.

Although the amount of a coupling material used is determined so as not to affect the conductivity of the conductors 42, the amount of a coupling material used may be determined so that a coverage rate of the coupling material on the surface of each of the conductors 42 (that is, a percentage of an area coated with the coupling material based on the entire surface area of a metal particle 42a is no less than 5%, preferably, 7 to 100 %, more preferably, 10 to 100 %, more particularly preferably, 20 to 100 %.

The intenna connecting apparatus 20 having such a structure is manufactured as follows. First, the conductive plate 30, which is plated with a predetermined metal, is inserted into a mold (not shown) having a predetermined cavity formed therein, and then a molding solution is injected into the mold. The molding solution is a silicon rubber solution that contains a plurality of conductor particles. After the injection of the molding solution, the molding solution is gradually hardened at room temperature, thereby completing the manufacture of the intenna connecting apparatus 20.

The intenna connecting apparatus 20 is mounted on the PCB 10, on which the intenna connecting apparatus 20 is required to be installed, and then fixed to the circuit patterns 11 by soldering. Thereafter, as illustrated in FIG. 4, the intenna 2 contacts an upper surface of the conductive medium 40. Then, as illustrated in FIG. 5, when the intenna 2 is pressed down, the conductors 42 separated from one another come in contact with one another because of the elastic polymer material 41. As the conductors 42 contact with one another as described above, an electrical connection is formed between the intenna 2, the conductive plate 30, and the circuit patterns 11 of the PCB 10.

In the intenna connecting apparatus 20 according to the present embodiment, the conductive medium 40 electrically connecting the conductive plate 30 to the intenna 2 is formed of an elastic rubber, and therefore the elasticity of the conductive medium 40 lasts for a long period of time. In particular, since a silicon rubber formed of an elastic polymer material is highly stable in terms of temperature and shape maintenance, the silicon rubber can maintain an initial electric connection without a change in its shape even when the silicon rubber is used for a long period of time. The conventional clip 120 of FIG. 2 may decrease its elasticity or may easily be destroyed at its curved portion when it is repeatedly used.

In addition, the conductors 42, which constitute the conductive medium 40, are coated with the conductive metal 42b (for example, gold), the diameters of the conductive particles 42a are 10 to 150µm, and the amount of the conductive metal 42b with which each of the metal particles 42a is coated is 5 to 25 % by weight. Thus, an optimal electrical connection between the conductive plate 30 and the intenna 2 is possible.

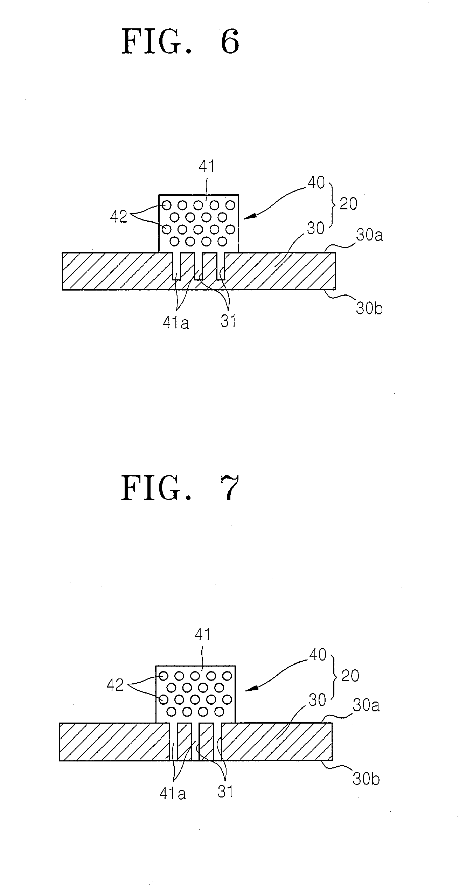

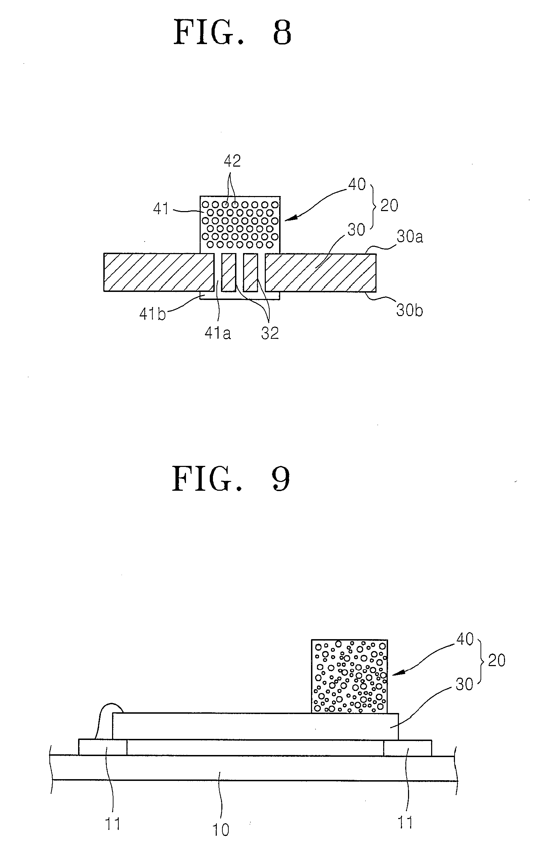

The intenna connecting apparatus 20 according to the present embodiment may be deformed as follows. First, in contrast with the aforementioned embodiment in which the elastic polymer material 41 formed of silicon is coupled with the upper surface of the conductive plate 30 formed of a metal, the other coupling methods illustrated in FIGS. 6 through 8 may be used in order to increase the coherence between the conductive plate 30 and the elastic polymer material 41. More specifically, referring to FIG. 6, a plurality of fixing grooves 31 may be formed within the conductive plate 30 from an upper surface 30a of the conductive plate 30 and extending towards but not arriving at a lower surface 30b thereof, and fixing portions 41 a formed of an elastic polymer material 41 may be formed within the fixing grooves 31 so as to be incorporated into the conductive medium 40. Referring to FIG. 7, a plurality of through holes 32 vertically penetrating the upper and lower surfaces 30a and 30b may be formed within the conductive plate 30, and the fixing portions 41 a formed of the elastic polymer material 41 may be formed within the through holes 32 so as to be incorporated into the conductive medium 40. Referring to FIG. 8, hooks 41 b are further included in the intenna connecting apparatus 20 in addition to the components illustrated in FIG. 7. The hooks 41 b cover at least some portions of the lower surface 30b of the conductive plate 30 and are integrally attached to the fixing portions 41 a. All of the coupling methods illustrated in FIGS. 6 through 8 increase a contact area between the conductive plate 30 and the elastic polymer material 41, thereby preventing the conductive medium 40 from slipping out of the conductive plate 30. The coupling method illustrated in FIG. 8 enables the conductive medium 40 and the conductive plate 30 to be firmly coupled with each other, since the contact area between the conductive plate 30 and the elastic polymer material 41 is the largest.

Furthermore, although the conductive medium 40 is located at the center of the upper surface 30a of the conductive plate 30 in the above-described embodiments, the conductive medium 40 may be located on the right portion of the upper surface 30a of the conductive plate 30 as illustrated in FIG. 9. Alternatively, the conductive medium 40 may be located on the left portion of the upper surface 30a of the conductive plate 30.

An intenna connecting apparatus according to the present invention connects an intenna to a PCB by using a conductive medium made up of an elastic polymer material and a conductor, thereby contributing to a stable electrical connection.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. An intenna connecting apparatus (20) for electrically connecting an intenna, which is inserted into a mobile communication terminal (1), to circuit patterns (11) of a printed circuit substrate (10) installed below the intenna, the intenna connecting apparatus comprising:
a conductive plate (30) electrically connected to the circuit patterns (11) of the printed circuit substrate; and
a conductive medium (40) installed on an upper surface of the conductive plate, the conductive medium comprising an elastic polymer material (41) and a plurality of conductors (42) contained in the elastic polymer material,
wherein as the intenna is pressed down on the conductive medium, the conductive medium (40) is compacted and the conductors (42) come into contact with each other, and thus the intenna (2) and the circuit patterns (11) of the printed circuit substrate (10) are electrically connected to each other.

2. The intenna connecting apparatus of claim 1, wherein:
fixing grooves (31) are formed within the conductive plate (30) so as to be dug from the upper surface (30a) of the conductive plate toward a lower surface (30b) of the conductive plate; and
fixing portions (41 a) formed of an elastic polymer material (41) are formed within the fixing grooves so as to be incorporated into the conductive medium.

3. The intenna connecting apparatus of claim 2, wherein:
through holes (32) are formed within the conductive plate (30) so as to penetrate the upper and lower surfaces (30a, 30b) of the conductive plate; and
fixing portions (41 a) formed of an elastic polymer material are formed within the through holes so as to be incorporated into the conductive medium.

4. The intenna connecting apparatus of claim 3, wherein hooks (41 b) that cover the lower surface (30b) of the conductive plate (30) and are formed of an elastic polymer material are integrally formed with the fixing portions (41 a).

5. The intenna connecting apparatus of one of claims 1 to 4, wherein the elastic polymer material (41) is a silicon rubber.

6. The intenna connecting apparatus of one of claims 1 to 5, wherein the conductive plate (30) is formed by plating a metal with one of tin and silver.

7. The intenna connecting apparatus of one of claims 1 to 6, wherein:
the conductors are formed by coating metal particles with gold, and surfaces of the conductors are treated with a coupling material, wherein the diameters of the metal particles are 10 to 150µm, the amount of the gold with which each of the metal particles is coated is 5 to 25 % by weight.

8. The intenna connecting apparatus of one of claims 1 to 7, wherein the conductive plate (30) is fixed to the circuit patterns of the printed circuit substrate (10) by soldering, and the conductive medium (40) is located on a central portion of the upper surface (30a) of the conductive plate.
